# EUROPEAN PATENT APPLICATION

(11) **EP 2 068 375 A1**
(43) Date of publication of application: **10.06.2009**
(21) Application number: 07122135.2
(22) Date of filing: 03.12.2007
(51) Int. Cl.: H01L 31/048

(54) **Flexible solar cell laminate comprising a crystalline semiconductor layer**

(71) Applicant: Tendris Solutions B.V., 1411 KC Naarden (NL)
(72) Inventor: Brouwer, Jeroen, 7964 KJ, Ansen (NL); Van der Hilst, Ramon, 1108 GA, Amsterdam ZO (NL); Neeb, Taco Wijnand, 1394 PE, NEDERHORST DEN BERG (NL)
(74) Representative: Rasser, Jacobus Cornelis

(57) **Abstract**

Disclosed is a flexible photovoltaic laminate comprising a photovoltaic semiconductor material. The flexible photovoltaic laminate may be manufactured without the use of adhesive, thereby avoiding light loss through absorption by an adhesive layer.

The laminate may be formed by forming a sandwich of the crystalline semiconductor material between layers of non-crosslinked cross-linkable polymer, followed by *in* situ cross-linking of the polymer.

The laminate may be incorporated in a curved surface of a structure, such as a boat hull or boat deck.

## Description

### BACKGROUND OF THE INVENTION

### 1. Field of the Invention

The invention relates generally to flexible solar cell laminates comprising a semiconductor layer, and more specifically to structures having a flexible solar cell laminate integrally incorporated in a curved surface thereof.

### 2. Description of the Related Art

Traditional solar cell panels comprise a layer of doped crystalline silicon as the semiconductor layer. The light-receiving surface of the solar cell is covered with a glass panel to provide protection. Although mechanically strong, glass is brittle. Traditional solar cell panels do not withstand the forces exerted by a person walking on top of them, or the impact of an object being dropped on them. Traditional solar panels are also heavy.

DE 103 56 690 discloses a crystalline silicon cell laminate covered with a rigid transparent polymer sheet, such as cycloaliphatic epoxy resin. The transparent layer may be provided with grooves so as to create a certain measure of flexibility. The panel sections between grooves are not flexible. The semiconductor material is taken up in recesses provided in the transparent polymer sheet.

Solar laminate foils have been proposed based on amorphous semiconductor materials. Although these materials are highly flexible, the energy efficiency is low, typically less than 10%, due to the use of amorphous semiconductor material. An example is the Uni-Solar product from United Solar Ovonic of Auburn Hills, MI, USA, which is based on amorphous silicon. Reportedly, this material has an energy efficiency of 6% (see DE 103 56 690 at paragraph [0004]). The materials are manufactured by laminating the semiconductor material between foils of polymer material.

DE 196 34 580 discloses a flexible photovoltaic laminate based on copper-indium-selenide (CIS). The energy efficiency is 12 to 14% (see col. 1, lines 24-27). The material is not strong enough to withstand impact forces, such as hail storms.

Thus, there is a need for a glass-free photovoltaic laminate that avoids the use of adhesive at least on the sun-exposed side of the semiconductor material. There is a further need for such laminate comprising a crystalline semiconductor material. There is a more particular need for such a laminate that is strong enough to withstand impact forces.

### BRIEF SUMMARY OF THE INVENTION

The present invention addresses these problems by providing a method for manufacturing a laminate comprising the steps of:
a) providing a first layer of a cross-linkable polymer material;
b) depositing at least one panel of a semiconductor material on top of said first layer of cross-linkable polymer material;
c) depositing a second layer of cross-linkable polymer material in contact with the first layer and the at least one panel of semiconductor material;
d) cross-linking said first layer and said second layer of cross-linkable material.

Another aspect of the invention is the photovoltaic laminate obtainable by this method.

### BRIEF DESCRIPTION OF THE DRAWINGS

The features and advantages of the invention will be appreciated upon reference to the following drawings, in which:

Fig 1 is a cross section view of a traditional photovoltaic cell comprising a crystalline silicon semiconductor and a glass cover.

FIG. 2 is a cross section view of one embodiment of the invention showing the layers of the laminate.

### DESCRIPTION OF ILLUSTRATIVE EMBODIMENTS

The following is a description of certain embodiments of the invention, given by way of example only and with reference to the drawings.

The present invention is based on the discovery that photovoltaic laminates may be manufactured whereby a semiconductor material is sandwiched between layers of cross-linkable polymer material, and subsequently the cross-linkable material is cross-linked. By this method it is possible to avoid the use of adhesives, thereby eliminating loss of incident sun energy as would result from absorption by an adhesive layer, such as ethylene vinyl acetate. The layer of adhesive present in a typical glass-covered solar panel of the prior art may absorb as much as 20 to 25% of the incident light.

The method makes it possible to provide a transparent polymer layer having a greater light transmission than the traditional glass cover. Polymer layers may be manufactured having a light transmission of from 80% to as much as 98%.

As compared to glass-covered solar panels, the weight of the laminates of the present invention is much reduced. For perspective, a traditional glass-covered panel of 1.60 x 0.80 meters has a weight of 17 kg, that is, 13.28 kg/m². A laminate manufactured by the method of the present invention weighs about 3 kg, or 2.34 kg/m². The demands on the structure onto which the panels are to be placed (such as roof structures) are much reduced, which reduces costs.

Traditional glass-covered panels have the disadvantage of being brittle. Any damage to such a panel is not conducive to repair. By contrast, the laminates of the present invention may be repaired by filling and polishing.

In a suitable embodiment the laminate comprises a plurality of sheets of semiconductor material, placed at some distance from each other. The resulting laminate panels may be drilled, screwed or nailed through the polymer layers in areas between the semiconductor sheets, without damage to the panels. This greatly increases the ease and cost of installation.

As mentioned above, the laminate does not require adhesive for adhering the semiconductor material to the polymer layers. A sheet of crystalline semiconductor material is adhered to the first layer and the second layer of polymeric material by a process comprising the steps of:
a) forming a first non-crosslinked layer of cross-linkable polymer;
b) depositing at least one sheet of semiconductor material onto said first layer;
c) forming a second non-crosslinked layer of cross-linkable polymer on top of the sheet of crystalline semiconductor material;
d) cross-linking the first and the second layer.
   It is important to avoid air bubbles in the polymer layers. It has been found that casting, if done carefully, results in a laminate substantially free of air bubbles. Optionally the cross-linking is carried out under vacuum, to ensure the removal of entrapped air and to provide optimal contact between the components of the laminate. This vacuum technique is particularly suitable for the manufacture of relatively rigid panels, intended for use in flat surfaces, such as roofs.

This *in situ* cross-linking results in optimal adherence of the sheet of semiconductor material to the two polymer layers. Since no adhesive is required, there is no loss of impinging light energy from light absorption by an adhesive layer.

The *in situ* cross-linking also results in a fusion of the first layer and the second layer in areas between and around the sheets of semiconductor material, so that the sheet or sheets of semiconductor material become embedded in a single layer of cross-linked polymer material.

Preferably the first non-crosslinked layer of cross-linkable polymer is formed on a non-adhering surface, such as a sheet of Teflon® foil spread out over a flat work surface. The layer of non-crosslinked polymer may be formed by any suitable means, such as spreading the polymer with a squeegee or spatula. In its non-crosslinked state the cross-linkable polymer material is a liquid.

Semiconductor material such as doped crystalline silicon is commercially available in the form of thin square sheets of about 12 x 12 cm or 1B x 1C cm. The desired number of squares is spread out on top of the first non-crosslinked layer of cross-linkable polymer. All necessary electric leads are first soldered to the semiconductor sheets, prior to depositing them onto the first layer of non-crosslinked layer of cross-linkable polymer. It will be understood that the wires forming the electric leads must be allowed to pass through this second layer.

Both layers of cross-linkable polymer are pre-mixed with the appropriate amount of cross-linking material, and the curing process starts as soon as the two components (polymer and cross-linker) are mixed. The amount of cross-linker is chosen so as to provide sufficient time to form the two layers, before hardening sets in. Upon curing a rigid or flexible laminate is obtained, depending on the thicknesses of the two polymer layers.

The polymer layer on the sun-facing side of the laminate must be transparent. Preferably, the polymer layer has a greater light transmission than glass of the same thickness. The second polymer layer may be of the same material as the first, ort of a different polymer material. Suitable cross-linkable polymer materials include epoxy, polyurethane, and polyacrylate. These materials are commercially available, and are generally sold with the appropriate cross-linking material.

It will be understood that the polymer layers may be thin enough to provide a flexible laminate. Many applications require panels that are stiff enough to keep their shape under the influence of gravity. This may be obtained by selecting polymer layers of sufficient thickness. It is possible to provide a support layer against the second polymer layer for further increasing the stiffness of the panel.

In a particularly preferred embodiment a layer of a heat conducting material is provided in heat conducting contact with the second polymer layer. The presence of the heat conducting layer makes it possible to withdraw heat from the panel. This is desirable, because the energy efficiency of solar panels is greater at lower operating temperatures. Heat develops in the panel as a result of less than 100% conversion of light energy to electric energy. Moreover, light of longer wavelengths, such as IR radiation, cannot be converted to electric energy.

Heat withdrawn from the panel may be used for purposes such as space heating, water heating, and the like.

Examples of suitable heat conducting materials include metal, boron nitride, and graphite.

An important feature of the laminate of the present invention is that it may comprise a crystalline semiconductor material. Crystalline semiconductor materials have a significantly greater energy efficiency (as defined by IEC Corm 60904-3) than the corresponding amorphous materials. For example, photovoltaic cells based on amorphous silicon have an energy efficiency of less than 10%, whereas photovoltaic cells based on crystalline GaAs have an energy efficiency on the order of 24 %.

By itself, a sheet of crystalline silicon is flexible, but extremely vulnerable. It has surprisingly been found that crystalline silicon can be embedded in a laminate of polymer material that is both flexible and strong.

The photovoltaic laminate of the present invention comprises one sheet or a plurality of sheets of a photovoltaic semiconductor material sandwiched between a first layer of polymeric material and a second layer of polymeric material. At least the first layer of polymeric material is transparent.

It is important that the sheet of crystalline semiconductor material is adhered to the first and the second layer of polymeric material, so as to prevent movement of the sheet of crystalline material relative to the first or second layer of polymeric material. The sheet of crystalline semiconductor material is adhered to the first and second polymer layer as a result of the *in situ* cross-linking of the polymer.

The polymer layers are made of a cross-linkable polymer material. Suitable examples include thermo-setting polyester materials, polyurethane, polyacrylate, and epoxy resins. The term "epoxy resin" as used herein generally refers to a crosslinked polymer of epichlorohydrin (chloromethyloxirane) and bisphenol-A (4,4'-dihydroxy-2,2-diphenylpropane).

Polyurethane and polyacrylate are highly transparent and have good resistance to u.v. radiation. For these reasons these two polymers are preferred for many applications of the laminate. Epoxy resin, although less transparent and less u.v. resistant than polyurethane or polyacrylate, may be preferred for incorporation into an epoxy-based structure. Suppliers of cross-linkable polymer materials in general supply the polymer with the appropriate amount of cross-linking monomer. The cross-linking monomer material is sometimes referred to as "catalyst" or "hardener".

The non-crosslinked polymer is a liquid. Upon reaction with the cross-linking material the polymer becomes a solid. The cross-linking reaction is sometimes referred to as "curing".

The method lends itself for the manufacture of flexible laminates. The term "flexible" as used herein with reference to the laminate describes the property that, when a local force is applied to the laminate in a direction generally perpendicular to the plane of the laminate the laminate will bend rather than break. The force required to bend the laminate generally depends on the thickness of the first and second layers. As described herein, the "first" layer is the layer that faces the sun when the photovoltaic structure is in use, and the "second" layer faces the supporting structure. It will be understood the manufacturing method may be adapted so that the "first" layer is the structure-facing layer, and the "second" layer is the sun-facing layer.

Depending on the intended application, the first layer may range in thickness from about 0.025 mm to about 3 mm. In general, it is desirable to keep this layer as thin as the structural requirements permit. Thicknesses in the range of 0.025 to 0.5 mm are preferred.

The second layer must be at least thick enough so as to fully embed the semiconductor sheets. In general the thickness will be determined by the desired structural strength of the laminate. Generally the thickness of the second layer ranges from 0.2 mm to 6 mm.

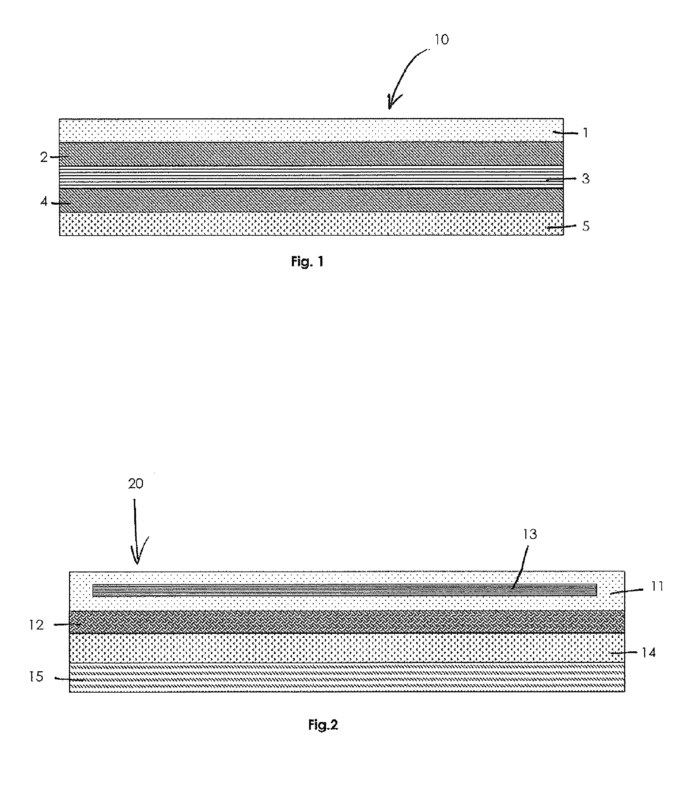

Figure 1 shows the structure of a traditional, glass-covered solar panel **10.** solar cells **3** are adhered to glass panel **1** by means of adhesive layer **2.** Adhesive layer **2** typically is an ethylene vinyl acetate (EVA) adhesive. The back of the panel comprises a polymer film **5,** which is adhered to the photovoltaic cells by means of adhesive layer **4.** Like adhesive layer **2,** adhesive layer **4** is typically made of EVA. Polymer film **5** is preferably white, so as to maximize reflection of sunlight back to cells **3.** In many cases the polymer film is a fluoropolymer film, such as Tedlar® from DuPont™.

To protect photovoltaic cells from air and humidity the stack is sealed at the edges by a sealing layer (not shown). 1n general, the sealed stack is further structurally protected by a rigid frame, such as a metal frame (also not shown). In particular the frame adds considerably to the weight of the panel.

Figure 2 shows an embodiment of the laminate of the present invention. Photovoltaic semiconductor sheets **13** are embedded within a cross-linked polymer layer **11.** As described hereinabove, polymer layer **11** is formed from two layers of non-crosslinked polymer that are fused together by subsequent cross-linking, thereby forming unitary layer **11.** The laminate consisting of semiconductor **13** and resin **11** may be used as-is, for incorporation into structural elements such as roof tiles, structural parts of boats and vehicles, and the like.

Further shown in Figure 2 is an optional reinforcement layer **12.** This layer may comprise reinforcing fibers, such as glass fibers, carbon fibers, aramid fibers, and the like. Also shown is thermal conducting layer **14,** which may be a flexible graphite sheet, a metal layer, or the like. The optional carrier layer **15** provides the desired structural strength. It will be understood that carrier layer **15** may also serve the function of heat conducting layer **14,** for example if a metal is used.

The flexible photovoltaic laminate of the present invention is particularly suitable to be incorporated into a surface of a structure, in particular a curved surface. Preferably the curved surface is formed of a polymer material, so that the laminate may be fully integrated with the surface.

The concept of integrating the flexible laminate in a curved surface will be illustrated with reference to a glass fiber reinforced polyester (GFRP) boat, but it will be appreciated that by similar techniques the flexible laminate may be incorporated into any flat or curved surface of any structure, such as campers, caravans, automobiles, buses, trucks, building structures, air craft, space craft, garden structures, and the like.

Generally, parts of a GFRP boat, such as the hull, the deck, cabin top, and the like, are formed in a mold. Basically, layers of glass mat and non-crosslinked epoxy or polyester are applied to the inside of the mold. Often the mold is first coated with a release wax, which ensures release of the boat part from the mold. In general, the wax is first covered with a sprayed-on layer of gel coat, which provides a color and durable finish to the part. After the layers of glass mat and cross-linkable polymer have been applied, the polymer is cross-linked. Often a reduced pressure is applied during the cross-linking, so as to remove entrapped air and to ensure optimum contact between the polymer and the glass fibers. It will be understood that, instead of or in addition to the glass fibers, other reinforcing materials may be used, such as aramid fibers, carbon fibers, and the like. The entire process is referred to as "lay up".

For the purpose of the present invention, flexible photovoltaic laminate panels are applied to the mold prior to the gel coat and any GFRP components. The panels may be attached to the mold using some type of temporary adhesive. The cross-linkable polymer used for the construction of the boat part in question is applied directly to the panels, thereby ensuring that the panels become integral parts of the structure.

After curing of the boat part it is removed from the mold. The photovoltaic laminate panels have become an integral part of the structure. The structure provides excellent support to the panels. The flexibility of the panels provides resistance to shattering and breaking. It has been found, for example, that the solar panels may be incorporated into the deck of a boat. The resulting structure is strong enough to allow crew to walk on the panels, for example during docking and anchoring maneuvers, without breaking the panels.

It will be understood that, during the lay up process, all electric leads from the solar panels are led through the GFRP structure. Upon assembly of the various parts of the boat the wires are connected to the overall wiring scheme of the boat. Electrical energy provided by the photovoltaic panels may be used for any desired electric load on board, such as lighting, cooling, heating, ventilation, cooking, navigation, propulsion, and the like. In general the electric energy is used to charge a bank of batteries, which in its turn feeds the electric loads on board.

In a preferred embodiment individual photovoltaic panels are connected in parallel, or small groups of panels are connected in series, with each group connected to other groups in parallel. Parallel circuitry has the advantage that poorly performing panels in the system do not drag down the overall performance of the system. A perceived disadvantage of parallel circuitry is the low voltage provided by the assembly of solar panels. This disadvantage can be overcome by our step-up circuit, which is the subject of our earlier patent application WO 06/041295, the disclosures of which are incorporated herein by reference.

## Claims

1. A method for manufacturing a photovoltaic laminate comprising the steps of:
a) providing a first layer of a cross-linkable polymer material;
b) depositing at least one panel of a semiconductor material on top of said first layer of cross-linkable polymer material;
c) depositing a second layer of cross-linkable polymer material in contact with the first layer and the at least one panel of semiconductor material;
d) cross-linking said first layer and said second layer of cross-linkable material.

2. The method of claim 1 wherein the cross-linkable polymer material of the first layer is identical to the polymer material of the second layer.

3. The method of claim 1 or 2 wherein the cross-linkable material upon cross-linking provides a transparent material.

4. The method of any one of the preceding claims wherein the cross-linkable material is selected from epoxy, polyurethane, and polyacrylate.

5. The method of any one of the preceding claims wherein the semiconductor material is doped silicon.

6. The method of any one of the preceding claims wherein the semiconductor material is a crystalline material.

7. The method of any one of the preceding claims wherein a support layer is added to the laminate in order to provide stiffness.

8. The method of any one of the preceding claims wherein a layer of heat conducting material is added to the laminate.

9. The method of any one of the preceding claim wherein the layer of heat conducting material comprises graphite, a metal, or boron nitride.

10. A photovoltaic laminate obtainable by the method of any one of the preceding claims.

11. the photovoltaic laminate of any one of the preceding claims wherein more than 80% of solar energy received by the first layer reaches the semiconductor material.

12. The photovoltaic laminate of claim 11 wherein more than 90% of solar energy received by the first layer reaches the semiconductor material.

13. The photovoltaic laminate of any one of claims 10 though 12 which is substantially free of adhesive in the light path to the semiconductor material.

14. The photovoltaic laminate of any one of claims 10 though 13 comprising a plurality of semiconductor panels connected in parallel.

15. The photovoltaic laminate of any one of claims 10 though 14 which is integrated with a collector for heat energy.

16. The photovoltaic laminate of claim 15 wherein the collector for heat energy collects at least one of the heat generated within the semiconductor material and heat energy received from the sun.

17. The photovoltaic laminate of any one of claims 10 though 15 which is rigid.

18. The photovoltaic laminate of any one of claims 10 through 15 which is flexible.

19. The photovoltaic laminate of any one of claims 10 through 18 which has a specific weight of less than 10 kg/m².

20. The photovoltaic laminate of claim 19 which has a specific weight of less than 5 kg/m².

21. The photovoltaic laminate of claim 18 when it is incorporated in a curved surface of a structure.

22. The photovoltaic laminate of claim 21 when it is incorporated in the part of a boat.

23. The flexible photovoltaic laminate of claim 22 when it is incorporated in the deck of a boat.

24. The photovoltaic laminate of claim 14 wherein the photovoltaic cells are connected to an electric load via a step-up circuit.
